# EUROPEAN PATENT SPECIFICATION

(11) **EP 4 567 875 B1**
(45) Date of publication and mention of the grant of the patent: **21.01.2026**
(21) Application number: 24172310.5
(22) Date of filing: 25.04.2024
(51) Int. Cl.: H10D 89/60, H10D 84/01, H10D 84/03, H10D 84/00, H10D 84/40, H10D 10/01, H10D 10/80

(54) **SILICON CONTROLLED RECTIFIER INTEGRATED HETEROJUNCTION BIPOLAR TRANSISTOR**
INTEGRIERTER HETEROÜBERGANG-BIPOLARTRANSISTOR MIT SILIZIUMGESTEUERTEM GLEICHRICHTER
TRANSISTOR BIPOLAIRE À HÉTÉROJONCTION À REDRESSEUR COMMANDÉ AU SILICIUM

(30) Priority: 04.12.2023 US 202318528223
(43) Date of publication of application: 11.06.2025
(60) Divisional application: 25192319.9
(73) Proprietor: GlobalFoundries U.S. Inc., Malta, NY 12020 (US)
(72) Inventor: NATH, Anindya, Essex Junction, VT, 05452 (US); RAGHUNATHAN, Uppili S., Essex Junction, VT, 05452 (US); KRISHNASAMY, Rajendran, Essex Junction, VT, 05452 (US); KARALKAR, Sagar Premnath, Essex Junction, VT, 05452 (US); DERRICKSON, Alexander M., Malta, NY, 12020 (US); JAIN, Vibhor, Essex Junction, VT, 05452 (US)
(74) Representative: Lambacher, Michael

(56) References cited:
- CN-A- 102 130 155
- CN-A- 105 374 816
- CN-A- 105 552 074
- CN-A- 113 270 427
- US-A1- 2003 047 750
- US-A1- 2011 068 364
- US-A1- 2023 163 123

## Description

### BACKGROUND

The present disclosure relates to semiconductor structures and, more particularly, to a heterojunction bipolar transistor integrated silicon controlled rectifier and methods of manufacture.

SCRs are used for electrostatic discharge (ESD) protection of integrated circuits (ICs) from the sudden flow of electricity caused by, for example, contact, electrical shorts, or dielectric breakdown. Because of high current handling ability per unit area of an SCR, ESD devices utilizing SCR can protect ICs from failure. These devices are most often used in high performance analog and radiofrequency (RF) designs for chips that have large signal swings, low leakage, and low capacitance. For example, the SCR may be used to protect antenna ports. Due to the capacitance loading and poor harmonics of SCRs, radiofrequency (RF) performance may be impacted.

From CN 105 552 074 A an SCR device is known which is composed of a parasitic pnp transistor, a parasitic npn transistor and a parasitic heterojunction bipolar transistor. Further, from CN 102 130 155 A an SCR structure is known, comprising an N-well in a substrate, a P-type lightly doped diffusion region above the N-well, an N-type impurity-doped SiGe region above the diffusion region, and a P-type impurity-doped polysilicon region above the SiGe region.

### SUMMARY

In an aspect of the disclosure, a structure comprises a heterojunction bipolar transistor integrated with a silicon controlled rectifier, comprising: a first region comprising a first dopant type provided in a semiconductor substrate; a second region comprising a second dopant type provided in the semiconductor substrate; an isolation region between the first region and the second region; a first semiconductor layer vertically contacting the first region, the first semiconductor layer having the second dopant type; a second semiconductor layer vertically contacting the second region, the second semiconductor layer having the first dopant type; a polycrystalline material vertically contacting the first semiconductor layer and having the second dopant type; and a semiconductor material having the first dopant type and vertically contacting the first semiconductor layer and the second semiconductor layer.
Additional features of the structure are set forth in dependent claims 2 to 14.

In an aspect of the disclosure, a method for manufacturing a heterojunction bipolar transistor integrated silicon controlled rectifier comprises: forming a first region comprising a first dopant type provided in a semiconductor substrate; forming a second region comprising a second dopant type provided in the semiconductor substrate, and an isolation region between the first region and the second region; forming a first semiconductor layer vertically contacting the first region, the first semiconductor layer having the second dopant type; forming a second semiconductor layer vertically contacting the second region, the second semiconductor layer having the first dopant type; forming a polycrystalline material vertically contacting the first semiconductor layer and having the second dopant type; and forming a semiconductor material having the first dopant type and vertically contacting the first semiconductor layer and the second semiconductor layer.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a device and respective fabrication processes in accordance with aspects of the present disclosure.
FIG. 1B shows a cross-sectional view of the device of FIG. 1A along line X1-X1 and respective fabrication processes in accordance with aspects of the present disclosure.
FIG. 2 shows a cross-sectional view of a device in accordance with additional aspects of the present disclosure.
FIG. 3 shows a cross-sectional view of another device not forming part of the claimed invention.
FIGS. 4A-4F show fabrication processes for manufacturing the device of FIG. 1 in accordance with aspects of the present disclosure.

### DETAILED DESCRIPTION

The present disclosure relates to semiconductor structures and, more particularly, to a heterojunction bipolar transistor integrated silicon controlled rectifier and methods of manufacture. More specifically, the present disclosure comprises a silicon controlled rectifier (SCR) integrated with a SiGe heterojunction bipolar transistor (HBT). Advantageously, the present disclosure provides lower capacitance, less RF degradation (vertical junctions and not well based junctions), fast switching time and higher current drive due to improved beta of the heterojunction bipolar transistor.

In more specific embodiments, the SCR comprises an n-type region and a p-type region on each side of a shallow trench isolation region. The n-type region and p-type region may be vertically contacted to a SiGe material of opposite doping type. In one embodiment, an N-type region of polysilicon bridges each SiGe region above a shallow trench isolation region or buried insulator layer. A P-type polysilicon material may also rest on a p-SiGe region. Compared to known solutions, a low trigger voltage SCR can be achieved with the high N+/ P+ regions of the extrinsic base profiles (e.g., SiGe regions). This structure will also save area and has a lower capacitance compared to diode triggered SCRs.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

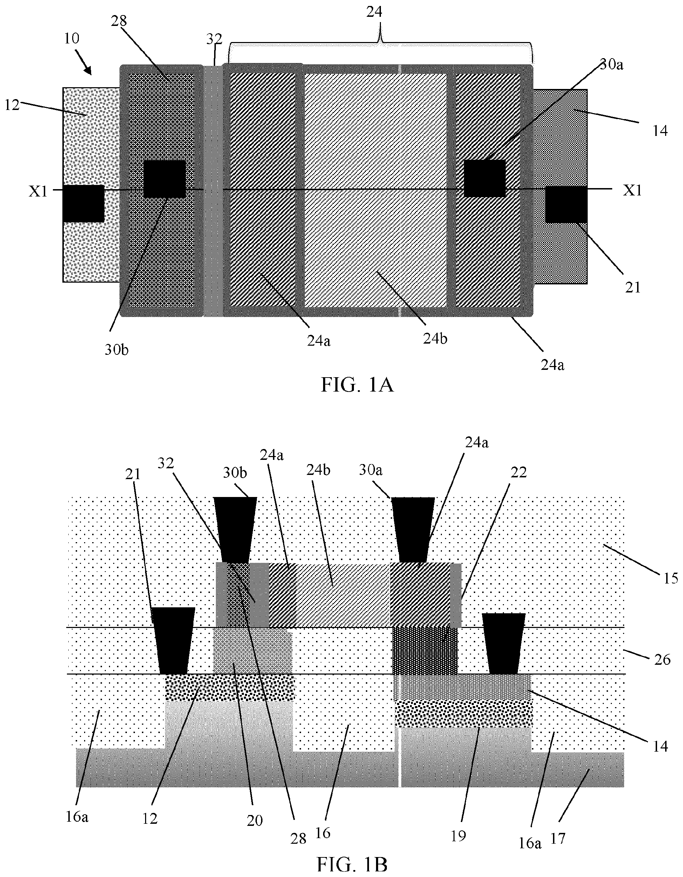

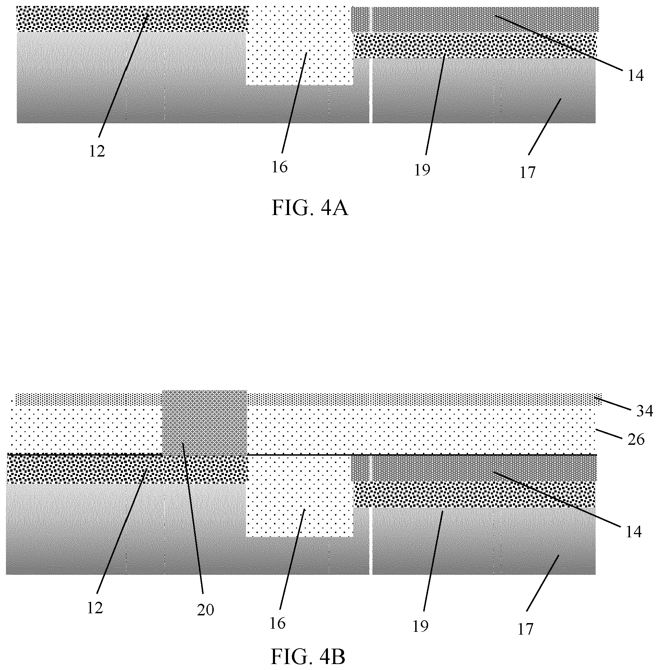

FIG. 1A shows a top view of a device and FIG. 1B shows a cross-sectional view of the device of FIG. 1A along line X1-X1. Referring to FIGS. 1A and 1B, the device 10 comprises an SCR comprising an n-type region 12 and a p-type region 14 on opposing sides of a shallow trench isolation region 16. The n-type region 12 and the p-type region 14 may be a sub-collector region of the heterojunction bipolar transistor. The p-type region 14 may be formed in or above an N-well 19 in semiconductor substrate 17. The n-type region 12, the p-type region 14 and the N-well 19 may be provided between shallow trench isolation regions 16, 16a. Accordingly, the n-p junctions are bounded by the shallow trench isolation regions 16, 16a thereby lowering parasitic capacitance. In embodiments, the doped regions 12, 14, 19 may be formed by ion implantation processes as is known in the art and as described with respect to FIG. 4A.

A contact 21 may be provided to both regions 12, 14, through an interlevel dielectric material 15. The interlevel dielectric material 15 may be, for example, layers of oxide and/or nitride material as is known in the art. The contacts 21 may be formed by conventional lithography, etching and deposition processes as described herein. Additionally, a conventional silicide process may be used to provide silicide contacts to the regions 12, 14, prior to the deposition of conductive material to form the contacts 21.

A collector region may be provided between the n-type region 12 and the p-type region 14 within the semiconductor substrate 17. The semiconductor substrate 17 may be composed of any suitable material and preferably p-type Si material. In embodiments, the semiconductor substrate 17 may be a single semiconducting material such as bulk silicon.

The n-type region 12 and the p-type region 14 are vertically below and contact a respective SiGe material 20, 22 of opposite doping type from the n-type region 12 and the p-type region 14. For example, the n-type region 12 vertically contacts a p-SiGe material 20 and the n-type region 12 vertically contacts an n-SiGe material 22. The respective SiGe materials 20, 22 may be extrinsic base regions of the bipolar heterojunction transistor.

An N-type region 24 may be provided over the n-SiGe material 22, which bridges to and contacts the p-type region 14. The N-type region 24 may comprise a single crystalline semiconductor material 24a and a polysilicon material 24b between the single crystalline semiconductor material 24a. The single crystalline N-type semiconductor material 24a is preferably Si material which contacts to the n-SiGe material 22 and the p-SiGe material 20; although other suitable semiconductor materials are also contemplated herein. In alternate embodiments, region 24a, may also comprise polycrystalline material.

The single crystalline N-type semiconductor material 24a contacts both the n-SiGe material 22 and the p-type region 14; whereas the polysilicon material 24b may be provided between the N-type single crystalline region 24a, spanning over a buried insulator material 26. The N-type single crystalline region 24a may be an emitter of the bipolar heterojunction transistor. The polysilicon material 24b will have a lower capacitance compared to diode triggered SCRs. A contact 30a may extend to and contact the respective N-type single crystalline region 24a. The buried insulator material 26 may be a buried oxide layer, as an example.

A P-type region 28 may be provided on the p-SiGe material 20. In embodiments, the P-type region 28 may be polysilicon material, which acts as an emitter region of an PNP HBT. A sidewall spacer 32 may isolate the P-type region 28 from the N-type region 24 and, more specifically, the N-type single crystalline region 24a contacting the p-SiGe material 20. A contact 30b may extend to and contact the P-type region 28.

It should be understood by those of ordinary skill in the art that the n-SiGe material 22 is shared between the SCR and the HBT. For example, in the embodiment shown in FIGS. 1A and 1B, the SCR is a p-n-p-n and the HBTs may be a PNP transistor and/or an NPN transistor. More specifically, the SCR comprises the p-type region 14, the n-SiGe material 22 and the N-type region 24, the p-type SiGe material 20 and the n-type region 12. Moreover, in embodiments, the PNP HBT may comprise the p-SiGe material 20, the N-type region 24 with the n-SiGe material 22 and the p-type region 14. On the other hand, the NPN HBT may comprise the n-type region 12, the p-SiGe material 20, and the n-SiGe material 22 with the N-type region 24.

Also, in these configurations, for example, a polysilicon material 24b will form a vertical junction (e.g., not a well-based junction) which lowers capacitance of the device, while also providing less RF degradation than conventional diode triggered SCRs. Moreover, the SiGe materials 20, 22, e.g., extrinsic base regions, will provide an improved beta resulting from a higher current drive. Also, as in each of the embodiments, the doped regions described herein may be formed by separate in-situ doping processes during epitaxial growth processes as described in more detail herein, with p-type dopants, e.g., Boron (B), and n-type dopants, e.g., Arsenic (As), Phosphorus (P) and Antimony (Sb), among other suitable examples.

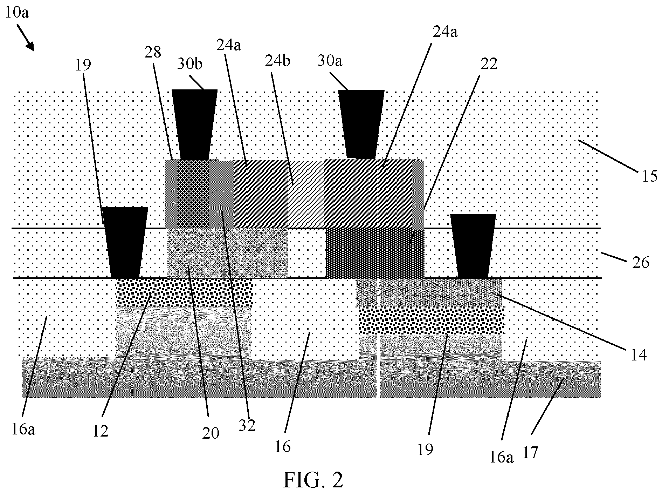

FIG. 2 shows a cross-sectional view of a device in accordance with additional aspects of the present disclosure. In the device 10a of FIG. 2, the p-SiGe material 20 and the n-SiGe material 22 extend over the shallow trench isolation region 16. That is, the p-SiGe material 20 and the n-SiGe material 22 overlap with the underlying shallow trench isolation region 16. Also, as in the device 10, the n-p junctions are bounded by the shallow trench isolation regions 16, 16a, thereby lowering parasitic capacitance. The remaining features of the structure 10a are similar to the structure 10 shown in FIGS. 1A and 1B such that no further explanation is required for a complete understanding of the present disclosure.

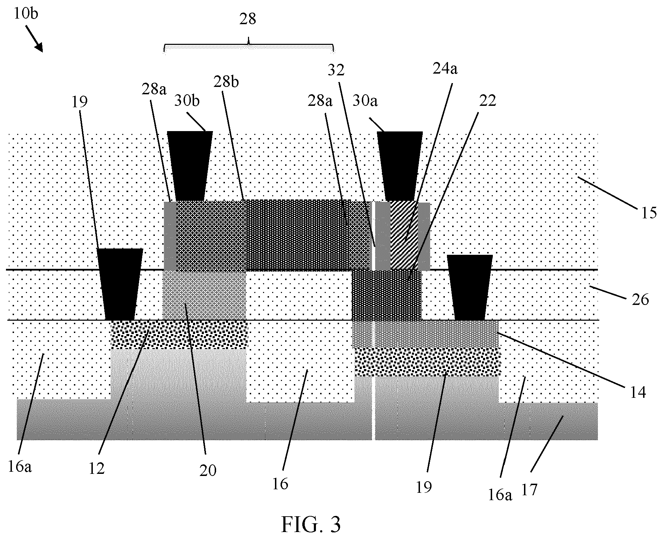

FIG. 3 shows a cross-sectional view of another device not forming part of the claimed invention. In the device 10b of FIG. 3, the N-type region 24 comprises single crystalline semiconductor material, e.g., Si material, on the n-SiGe material 22. In this embodiment, there is no n-type polysilicon material between the single crystalline semiconductor material 24a as is shown in FIGS. 1A and 1B. Instead, in this embodiment, the P-type region 28 comprises a single crystalline semiconductor material 28a and a polysilicon material 28b between the single crystalline semiconductor material 28a. The single crystalline P-type semiconductor material 28a is preferably Si material; although other suitable semiconductor materials are also contemplated herein. The polysilicon material 28b spans over the buried insulator material 26, with the single crystalline P-type semiconductor material 28a contacting both the p-SiGe material 20 and the n-SiGe material 22. In further embodiments, the n-type region 12 may be a p-type region.

FIGS. 4A-4F show fabrication processes for manufacturing the device 10 of FIGS. 1A and 1B in accordance with aspects of the present disclosure. It should be understood by those of skill in the art that FIGS. 4A-4F may also represent fabrication processes for manufacturing the devices of FIGS. 2 and 3 by, for example, using different in-situ dopants during epitaxial growth processes as described herein. In embodiments, the sub-collector regions may be formed by ion implantation processes as is known in the art such that no further explanation is required for a complete understanding of the present disclosure.

In FIG. 4A, for example, the n-type region 12, N-well 19 and p-type region 14 are formed by conventional ion implantation processes performed on the semiconductor substrate 17. By way of example, the n-type region 12, N-well 19 and p-type region 14 may be formed by introducing a concentration of different dopants in the semiconductor substrate 17 using different masking and implantation steps.

In more specific embodiments, for example, respective patterned implantation masks may be used to define selected areas exposed for the implantations. For example, a first patterned implantation mask is used to select the exposed area for forming the n-type region 12 and the N-well 19 is stripped after implantation, and before a second patterned implantation mask is used to form the p-type region 14. Similarly, the second patterned implantation mask used to select the exposed area for forming the p-type region 14 is stripped after the implantation is performed. The implantation masks may include a layer of a light-sensitive material, such as an organic photoresist, applied by a spin coating process, pre-baked, exposed to light projected through a photomask, baked after exposure, and developed with a chemical developer. Each of the implantation masks has a thickness and stopping power sufficient to block masked areas against receiving a dose of the implanted ions. The p-type region 14 is doped with p-type dopants, e.g., Boron (B), and the n-type region 12 and N-well 19 are doped with n-type dopants, e.g., Arsenic (As), Phosphorus (P) and Sb, among other suitable examples.

Still referring to FIG. 4A, the shallow trench isolation region 16 is formed between the n-type region 12 and the p-type region 14. The shallow trench isolation region 16 can be formed by conventional lithography, etching and deposition methods known to those of skill in the art. For example, a resist formed over the semiconductor substrate 17 is exposed to energy (light) and developed utilizing a conventional resist developer to form a pattern (opening). An etching process with a selective chemistry, e.g., reactive ion etching (RIE), will be used to transfer the pattern from the patterned photoresist layer to the semiconductor substrate 17 to form one or more trenches in the semiconductor substrate 17. Following the resist removal by a conventional oxygen ashing process or other known stripants, insulator material (e.g., SiO₂) can be deposited by any conventional deposition processes, e.g., chemical vapor deposition (CVD) processes. Any residual material on the surface of the semiconductor substrate 17 can be removed by conventional chemical mechanical polishing (CMP) processes.

In FIG. 4B, the p-SiGe material 20 is formed over the n-type region 12. To form the p-SiGe material 20, the insulator material 26 is deposited over the semiconductor substrate 17. The insulator material 26 may be deposited by any conventional deposition method, e.g., CVD. A masking layer 34 is deposited on the insulator material 26. The masking layer 34 may be nitride, deposited by a conventional deposition method, e.g., CVD. An opening is formed through the buried insulator material 26 and masking layer 34 to expose the underlying n-type region 12. The opening may be formed by conventional lithography and etching processes as is known in the art. A SiGe material is epitaxially grown on the exposed underlying n-type region 12. In embodiments, the epitaxial growth process includes an in-situ doping process with a p-type dopant to form the p-SiGe material 20.

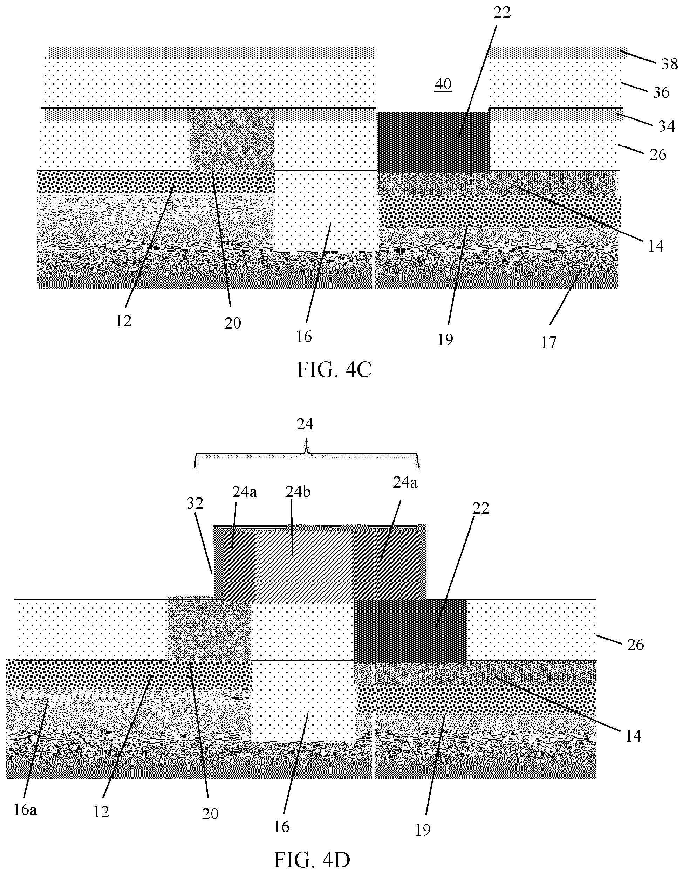

In FIG. 4C, the n-SiGe material 22 is formed over the p-type region 14. To form the n-SiGe material 22, insulator material 36 and masking layer 38 are formed over masking layer 34 using any conventional deposition method, e.g., CVD. As an example, the insulator material 36 may also be oxide and the masking layer 38 may also be nitride. An opening is formed through the insulator materials 26, 36 and masking layers 34, 38 to expose the underlying p-type region 14, again using conventional lithography and etching processes. A SiGe material is epitaxially grown on the exposed underlying p-type region 14. In embodiments, the epitaxial growth process includes an in-situ doping process with an n-type dopant to form the n-SiGe material 22.

In FIG. 4D, the N-type region 24, e.g., N-type single crystalline region 24a and polysilicon material 24b, may be formed over the p-SiGe material 20, the n-SiGe material 22 and the buried insulator layer 26. Prior to forming the N-type region 24, the insulator material 36 and masking layer 38 may be removed by conventional removal processes, e.g., CMP or etching processes. In this way, the p-SiGe material 20, the n-SiGe material 22 and the insulator material 26 are exposed. The N-type region 24 may be epitaxially grown from the p-type region 14 and n-type region 12, bridging over the insulator material 26. In alternate embodiments, the region 24 may also be deposited using CVD processes. The epitaxial growth process may include an in-situ doping process with an N-type dopant, e.g., Arsenic. As is known in the art, the polysilicon material 24b will form over the insulator material 26. It should also be understood that a similar process may be used to form the P-type region 28, e.g., regions 28a, 28b which bridge between the p-SiGe material 20 and the n-SiGe material 22 as shown in FIG. 3. Following a conventional patterning process, a sidewall spacer material 32, e.g., nitride, may be deposited and patterned over the N-type region 24.

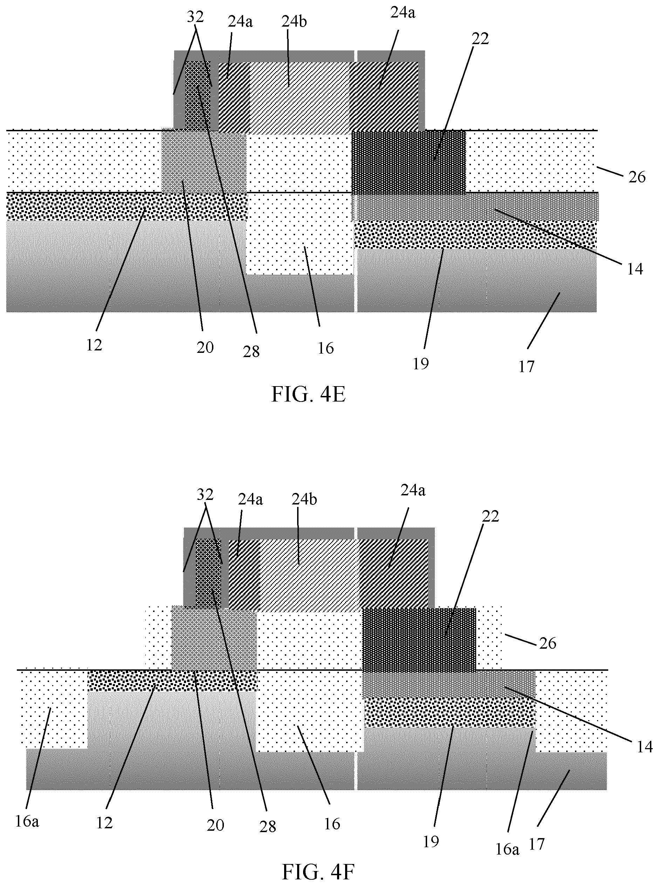

In FIG. 4E, the P-type region 28 may be formed over the p-SiGe material 20. The P-type region 28 is epitaxially grown from the p-SiGe material 20, with a p-type in-situ doping process. Following a conventional patterning process, the sidewall spacer material 32, e.g., nitride, may be deposited over the P-type region 28. It should be understood that a similar process may be used to form the N-type region 24 as shown in FIG. 3.

In FIG. 4F, the buried insulator material 26 may be patterned, e.g., recessed, to expose the underlying semiconductor substrate 17. The shallow trench isolation regions 16, 16a may be formed using conventional lithography, etching and deposition processes as already described herein. The shallow trench isolation regions 16a may be used to isolate the p-type region 14 and n-type region 12. The isolation region 16a in the underlying exposed semiconductor substrate 17 may also be a deep trench isolation region.

Referring back to FIG. 1B, for example, the contacts 21, 30a, 30b may be formed through the interlevel dielectric material 15 by conventional lithography, etching and deposition processes as is known in the art. Prior to the deposition of conductive material to form the contacts 21, 30a, 30b, a conventional silicide process may be used to provide silicide contacts to the regions 12, 14, 24a, 28.

As should be understood by those of skill in the art, the silicide process begins with deposition of a thin transition metal layer, e.g., nickel, cobalt or titanium, over the exposed regions 12, 14, 24a, 28. After deposition of the material, the structure is heated allowing the transition metal to react with exposed silicon (or other semiconductor material as described herein) forming a low-resistance transition metal silicide. Following the reaction, any remaining transition metal is removed by chemical etching, leaving silicide contacts in the active regions of the device.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising a heterojunction bipolar transistor integrated silicon controlled rectifier, comprising:
a first region (12) comprising a first dopant type provided in a semiconductor substrate (17);
a second region (14) comprising a second dopant type provided in the semiconductor substrate (17);
an isolation region (16) between the first region (12) and the second region (14);
a first semiconductor layer (20) vertically contacting the first region (12), the first semiconductor layer (20) having the second dopant type;
a second semiconductor layer (22) vertically contacting the second region (14), the second semiconductor layer (22) having the first dopant type;
a polycrystalline material (28) vertically contacting the first semiconductor layer (20) and having the second dopant type; and
a semiconductor material (24) having the first dopant type and vertically contacting the first semiconductor layer (20) and the second semiconductor layer (22).

2. The structure of claim 1, wherein the first dopant type is an n-type dopant and the second dopant type is a p-type dopant.

3. The structure of claim 1 or claim 2, wherein the first region (12) and the second region (14) comprise Si material, and the first semiconductor layer (20) and the second semiconductor layer (22) comprise SiGe material, and, optionally, wherein the first semiconductor layer (20) comprises p-type SiGe material and the second semiconductor layer (22) comprises n-type SiGe material.

4. The structure of claim 3, wherein the polycrystalline material (28) is p-type semiconductor material and the semiconductor material (24) is n-type semiconductor material.

5. The structure of claim 4, further comprising n-type polysilicon material (24b) between the semiconductor material (24), which bridges over an insulator material between the first semiconductor layer (20) and the second semiconductor layer (22).

6. The structure of one of claims 1 to 5, wherein the second region (14) sits in a well (19) of the first dopant type.

7. The structure of claim 1, wherein the first dopant type is p-type dopant, the second dopant type is n-type dopant, the first semiconductor layer (20) comprises n-type SiGe material, the second semiconductor layer (22) comprises p-type SiGe material, the polycrystalline material (28) is n-type semiconductor material and the semiconductor material (24) is p-type semiconductor material.

8. The structure of claim 7, further comprising p-type polysilicon material (24b) between the semiconductor material (24), which bridges over an insulator material between the first semiconductor layer (20) and the second semiconductor layer (22).

9. The structure of one of claims 1 to 8, wherein the structure further comprises contacts (21, 30a, 30b) connecting to the first region (12), the second region (14), the first semiconductor layer (20) and the second semiconductor layer (22).

10. The structure of claim 1, wherein the second semiconductor layer (22) is shared between the heterojunction bipolar transistor and the silicon controlled rectifier, wherein the second semiconductor layer (22) comprises a base of the heterojunction bipolar transistor and is isolated from an underlying well (19) having the first dopant type by the second region (14).

11. The structure of claim 10, wherein the second semiconductor layer (22) comprises n-SiGe material, the underlying well (19) comprises an N-well in a p-type semiconductor substrate (17) and the second region (14) comprises a p-type sub-collector region of the heterojunction bipolar transistor.

12. The structure of claim 11, wherein the heterojunction bipolar transistor comprises an NPN transistor and a PNP transistor, and/or wherein the silicon controlled rectifier is p-n-p-n.

13. The structure of claim 12, wherein the first semiconductor layer (20) comprises p-SiGe material, the first region (12) comprises an n-type region in the underlying semiconductor substrate (17), and the semiconductor material (24) comprises an N-type region, wherein the PNP transistor comprises the p-SiGe material, the n-SiGe material with the N-type region above the n-SiGe, and the second region (14) , and/or wherein the NPN transistor comprises the n-type region in the underlying semiconductor substrate (17), the p-SiGe material, and the n-SiGe material with the N-type region above the n-SiGe material.

14. The structure of claim 13, wherein the silicon controlled rectifier comprises the second region (14), the n-SiGe material with the N-type region, the p-SiGe material and the n-type region under the p-SiGe material.

15. A method for manufacturing a heterojunction bipolar transistor integrated silicon controlled rectifier, comprising:
forming a first region (12) comprising a first dopant type provided in a semiconductor substrate (17);
forming a second region (14) comprising a second dopant type provided in the semiconductor substrate (17), and an isolation region (16) between the first region (12) and the second region (14);
forming a first semiconductor layer (20) vertically contacting the first region (12), the first semiconductor layer (20) having the second dopant type;
forming a second semiconductor layer (22) vertically contacting the second region (14), the second semiconductor layer (22) having the first dopant type;
forming a polycrystalline material (28) vertically contacting the first semiconductor layer (20) and having the second dopant type; and
forming a semiconductor material (24) having the first dopant type and vertically contacting the first semiconductor layer (20) and the second semiconductor layer (22).

## Patentansprüche

1. Struktur umfassend einen Heterojunction-Bipolartransistor-integrierten siliziumgesteuerten Gleichrichter, umfassend:
eine erste Region (12) umfassend einen ersten Dotierstofftyp, der in einem Halbleitersubstrat (17) vorgesehen ist;
eine zweite Region (14) umfassend einen zweiten Dotierstofftyp, der in dem Halbleitersubstrat (17) vorgesehen ist;
eine Isolationsregion (16) zwischen der ersten Region (12) und der zweiten Region (14);
eine erste Halbleiterschicht (20), welche die erste Region (12) vertikal kontaktiert, wobei die erste Halbleiterschicht (20) den zweiten Dotierstofftyp aufweist;
eine zweite Halbleiterschicht (22), welche die zweite Region (14) vertikal kontaktiert, wobei die zweite Halbleiterschicht (22) den ersten Dotierstofftyp aufweist;
ein polykristallines Material (28), welches die erste Halbleiterschicht (20) vertikal kontaktiert und den zweiten Dotierstofftyp aufweist; und
ein Halbleitermaterial (24), das den ersten Dotierstofftyp aufweist und die erste Halbleiterschicht (20) und die zweite Halbleiterschicht (22) vertikal kontaktiert.

2. Struktur nach Anspruch 1, wobei der erste Dotierstofftyp ein n-Typ-Dotierstoff ist und der zweite Dotierstofftyp ein p-Typ-Dotierstoff ist.

3. Struktur nach Anspruch 1 oder Anspruch 2, wobei die erste Region (12) und die zweite Region (14) Si-Material umfassen, und die erste Halbleiterschicht (20) und die zweite Halbleiterschicht (22) SiGe-Material umfassen, und wobei optional die erste Halbleiterschicht (20) p-Typ-SiGe-Material umfasst und die zweite Halbleiterschicht (22) n-Typ-SiGe-Material umfasst.

4. Struktur nach Anspruch 3, wobei das polykristalline Material (28) ein p-Typ-Halbleitermaterial ist und das Halbleitermaterial (24) ein n-Typ-Halbleitermaterial ist.

5. Struktur nach Anspruch 4, ferner umfassend ein n-Typ-Polysiliziummaterial (24b) zwischen dem Halbleitermaterial (24), welches ein Isolatormaterial zwischen der ersten Halbleiterschicht (20) und der zweiten Halbleiterschicht (22) überbrückt.

6. Struktur nach einem der Ansprüche 1 bis 5, wobei die zweite Region (14) in einer Wanne (19) des ersten Dotierstofftyps sitzt.

7. Struktur nach Anspruch 1, wobei der erste Dotierstofftyp ein p-Typ-Dotierstoff ist, der zweite Dotierstofftyp ein n-Typ-Dotierstoff ist, die erste Halbleiterschicht (20) ein n-Typ-SiGe-Material umfasst, die zweite Halbleiterschicht (22) ein p-Typ-SiGe-Material umfasst, das polykristalline Material (28) ein n-Typ-Halbleitermaterial ist und das Halbleitermaterial (24) ein p-Typ-Halbleitermaterial ist.

8. Struktur nach Anspruch 7, ferner umfassend ein p-Typ-Polysiliziummaterial (24b) zwischen dem Halbleitermaterial (24), welches ein Isolatormaterial zwischen der ersten Halbleiterschicht (20) und der zweiten Halbleiterschicht (22) überbrückt.

9. Struktur nach einem der Ansprüche 1 bis 8, wobei die Struktur ferner Kontakte (21, 30a, 30b) umfasst, die mit der ersten Region (12), der zweiten Region (14), der ersten Halbleiterschicht (20) und der zweiten Halbleiterschicht (22) verbunden sind.

10. Struktur nach Anspruch 1, wobei die zweite Halbleiterschicht (22) zwischen dem Heterojunction-Bipolartransistor und dem siliziumgesteuerten Gleichrichter gemeinsam genutzt wird, wobei die zweite Halbleiterschicht (22) eine Basis des Heterojunction-Bipolartransistors umfasst und von einer darunterliegenden Wanne (19), die den ersten Dotierstofftyp aufweist, durch die zweite Region (14) isoliert ist.

11. Struktur nach Anspruch 10, wobei die zweite Halbleiterschicht (22) ein n-SiGe-Material umfasst, die darunterliegende Wanne (19) eine N-Wanne in einem p-Typ- Halbleitersubstrat (17) umfasst und die zweite Region (14) eine p-Typ-Sub-Kollektor-Region des Heterojunction-Bipolartransistors umfasst.

12. Struktur nach Anspruch 11, wobei der Heterojunction-Bipolartransistor einen NPN-Transistor und einen PNP-Transistor umfasst, und/oder wobei der siliziumgesteuerte Gleichrichter p-n-p-n ist.

13. Struktur nach Anspruch 12, wobei die erste Halbleiterschicht (20) p-SiGe-Material umfasst, die erste Region (12) eine n-Typ-Region in dem darunterliegenden Halbleitersubstrat (17) umfasst, und das Halbleitermaterial (24) eine N-Typ-Region umfasst, wobei der PNP-Transistor das p-SiGe-Material, das n-SiGe-Material mit der N-Typ-Region über dem n-SiGe, und die zweite Region (14) umfasst, und/oder wobei der NPN-Transistor die n-Typ-Region in dem darunterliegenden Halbleitersubstrat (17), das p-SiGe-Material, und das n-SiGe-Material mit der N-Typ-Region über dem n-SiGe-Material umfasst.

14. Struktur nach Anspruch 13, wobei der siliziumgesteuerte Gleichrichter die zweite Region (14), das n-SiGe-Material mit der N-Typ-Region, das p-SiGe-Material und die n-Typ-Region unter dem p-SiGe-Material umfasst.

15. Verfahren zum Herstellen eines Heterojunction-Bipolartransistor-integrierten siliziumgesteuerten Gleichrichters, umfassend:
Bilden einer ersten Region (12) umfassend einen ersten Dotierstofftyp, der in einem Halbleitersubstrat (17) vorgesehen ist;
Bilden einer zweiten Region (14) umfassend einen zweiten Dotierstofftyp, der in dem Halbleitersubstrat (17) vorgesehen ist, und einer Isolationsregion (16) zwischen der ersten Region (12) und der zweiten Region (14);
Bilden einer ersten Halbleiterschicht (20), welche die erste Region (12) vertikal kontaktiert, wobei die erste Halbleiterschicht (20) den zweiten Dotierstofftyp aufweist;
Bilden einer zweiten Halbleiterschicht (22), welche die zweite Region (14) vertikal kontaktiert, wobei die zweite Halbleiterschicht (22) den ersten Dotierstofftyp aufweist;
Bilden eines polykristallinen Materials (28), welches die erste Halbleiterschicht (20) vertikal kontaktiert und den zweiten Dotierstofftyp aufweist; und
Bilden eines Halbleitermaterials (24), das den ersten Dotierstofftyp aufweist und die erste Halbleiterschicht (20) und die zweite Halbleiterschicht (22) vertikal kontaktiert.

## Revendications

1. Structure comprenant un rectifieur contrôlé par du silicium intégré à un transistor bipolaire d'hétérojonction, comprenant :
une première région (12) comprenant un premier type de dopant fourni dans un substrat semi-conducteur (17) ;
une seconde région (14) comprenant un second type de dopant fourni dans le substrat semi-conducteur (17) ;
une région d'isolation (16) entre la première région (12) et la seconde région (14) ;
une première couche semi-conductrice (20) entrant verticalement en contact avec la première région (12), la première couche semi-conductrice (20) ayant le second type de dopant ;
une seconde couche semi-conductrice (22) entrant verticalement en contact avec la seconde région (14), la seconde couche semi-conductrice (22) ayant le premier type de dopant ;
un matériau polycristallin (28) entrant verticalement en contact avec la première couche semi-conductrice (20) et ayant le second type de dopant ; et
un matériau semi-conducteur (24) ayant le premier type de dopant et entrant verticalement en contact avec la première couche semi-conductrice (20) et la seconde couche semi-conductrice (22).

2. Structure selon la revendication 1, dans laquelle le premier type de dopant est un dopant de type n et le second type de dopant est un dopant de type p.

3. Structure selon la revendication 1 ou la revendication 2, dans laquelle la première région (12) et la seconde région (14) comprennent un matériau Si, et la première couche semi-conductrice (20) et la seconde couche semi-conductrice (22) comprennent un matériau SiGe, et, éventuellement, dans laquelle la première couche semi-conductrice (20) comprend un matériau SiGe de type p et la seconde couche semi-conductrice (22) comprend un matériau SiGe de type n.

4. Structure selon la revendication 3, dans laquelle le matériau polycristallin (28) est un matériau semi-conducteur de type p et le matériau semi-conducteur (24) est un matériau semi-conducteur de type n.

5. Structure selon la revendication 4, comprenant en outre un matériau de polysilicium (24b) de type n entre le matériau semi-conducteur (24), qui établit un pont sur un matériau isolant entre la première couche semi-conductrice (20) et la seconde couche semi-conductrice (22).

6. Structure selon l'une des revendications 1 à 5, dans laquelle la seconde région (14) repose dans un puits (19) du premier type de dopant.

7. Structure selon la revendication 1, dans laquelle le premier type de dopant est un dopant de type p, le second type de dopant est un dopant de type n, la première couche semi-conductrice (20) comprend un matériau SiGe de type n, la seconde couche semi-conductrice (22) comprend un matériau SiGe de type p, le matériau polycristallin (28) est un matériau semi-conducteur de type n et le matériau semi-conducteur (24) est un matériau semi-conducteur de type p.

8. Structure selon la revendication 7, comprenant en outre un matériau de polysilicium (24b) de type p entre le matériau semi-conducteur (24), qui établit un pont sur un matériau isolant entre la première couche semi-conductrice (20) et la seconde couche semi-conductrice (22).

9. Structure selon l'une des revendications 1 à 8, dans laquelle la structure comprend en outre des contacts (21, 30a, 30b) connectant à la première région (12), la seconde région (14), la première couche semi-conductrice (20) et la seconde couche semi-conductrice (22).

10. Structure selon la revendication 1, dans laquelle la seconde couche semi-conductrice (22) est partagée entre le transistor bipolaire d'hétérojonction et le rectifieur contrôlé par du silicium, dans laquelle la seconde couche semi-conductrice (22) comprend une base du transistor bipolaire d'hétérojonction et est isolée d'un puits (19) sous-jacent ayant le premier type de dopant par la seconde région (14).

11. Structure selon la revendication 10, dans laquelle la seconde couche semi-conductrice (22) comprend un matériau SiGe de type n, le puits (19) sous-jacent comprend un puits N dans un substrat semi-conducteur (17) de type p et la seconde région (14) comprend une région sous-collectrice de type p du transistor bipolaire d'hétérojonction.

12. Structure selon la revendication 11, dans laquelle le transistor bipolaire d'hétérojonction comprend un transistor NPN et un transistor PNP, et/ou dans laquelle le rectifieur contrôlé par du silicium est p-n-p-n.

13. Structure selon la revendication 12, dans laquelle la première couche semi-conductrice (20) comprend un matériau SiGe de type p, la première région (12) comprend une région de type n dans le substrat semi-conducteur (17) sous-jacent, et le matériau semi-conducteur (24) comprend une région de type N, dans laquelle le transistor PNP comprend le matériau SiGe de type p, le matériau SiGe de type n avec la région de type N au-dessus du SiGe de type n, et la seconde région (14), et/ou dans laquelle le transistor NPN comprend la région de type n dans le substrat semi-conducteur (17) sous-jacent, le matériau SiGe de type p, et le matériau SiGe de type n avec la région de type N au-dessus du matériau SiGe de type n.

14. Structure selon la revendication 13, dans laquelle le rectifieur contrôlé par du silicium comprend la seconde région (14), le matériau SiGe de type n avec la région de type **N,** le matériau SiGe de type p et la région de type n sous le matériau SiGe de type p.

15. Procédé de fabrication d'un rectifieur contrôlé par du silicium intégré à un transistor bipolaire d'hétérojonction, comprenant les étapes consistant à :
former une première région (12) comprenant un premier type de dopant fourni dans un substrat semi-conducteur (17) ;
former une seconde région (14) comprenant un second type de dopant fourni dans le substrat semi-conducteur (17), et une région d'isolation (16) entre la première région (12) et la seconde région (14) ;
former une première couche semi-conductrice (20) entrant verticalement en contact avec la première région (12), la première couche semi-conductrice (20) ayant le second type de dopant ;
former une seconde couche semi-conductrice (22) entrant verticalement en contact avec la seconde région (14), la seconde couche semi-conductrice (22) ayant le premier type de dopant ;
former un matériau polycristallin (28) entrant verticalement en contact avec la première couche semi-conductrice (20) et ayant le second type de dopant ; et
former un matériau semi-conducteur (24) ayant le premier type de dopant et entrant verticalement en contact avec la première couche semi-conductrice (20) et la seconde couche semi-conductrice (22).
